# NEUE EUROPÄISCHE PATENTSCHRIFT

(11) **EP 0 855 035 B2**
(45) Veröffentlichungstag und Bekanntmachung des Hinweises auf die Entscheidung über den Einspruch: **14.12.2005**
(45) Hinweis auf die Patenterteilung: 14.07.1999
(21) Anmeldenummer: 96934479.5
(22) Anmeldetag: 27.09.1996
(51) Int. Cl.: G01R 13/34

(54) **BETRIEBSVERFAHREN FÜR EINE EINGANGSSCHALTUNG UND HIERZU KORRESPONDIERENDE EINGANGSSCHALTUNG**
OPERATING PROCESS FOR AN INPUT CIRCUIT AND CORRESPONDING INPUT CIRCUIT
PROCEDE PERMETTANT DE FAIRE FONCTIONNER UN CIRCUIT D'ENTREE ET CIRCUIT D'ENTREE CORRESPONDANT

(30) Priorität: 09.10.1995 EP 95115874
(43) Veröffentlichungstag der Anmeldung: 29.07.1998
(73) Patentinhaber: SIEMENS AKTIENGESELLSCHAFT, 80333 München (DE)
(72) Erfinder: SCHEUERER, Roland, D-92224 Amberg (DE); KÖCK, Günter, D-90451 Nürnberg (DE)
(86) Internationale Anmeldenummer: PCT/EP1996/004233
(87) Internationale Veröffentlichungsnummer: WO 1997/014043

(56) Entgegenhaltungen:
- US-A- 3 755 690
- PATENT ABSTRACTS OF JAPAN vol. 7, no. 184 (P-216) [1329] , 13.August 1983 & JP,A,58 087467 (IWASAKI TSUSHINKI KK), 25.Mai 1983,
- WABCO Schaltplan 4461031032

## Beschreibung

Die vorliegende Erfindung betrifft ein Betriebsverfahren für eine Eingangsschaltung, der ein Eingangssignal zugeführt wird, und die Eingangsschaltung gemäß dem Oberbegriff des Anspruchs 6.

Bei Eingangsschaltungen des Standes der Technik wird dieser kontinuierlich ein Eingangssignal zugeführt, welches ebenfalls kontinuierlich an einer Signalerfassungsschaltung ansteht. In Abständen wird das Eingangssignal dann von der Signalerfassungsschaltung tatsächlich übernommen, ausgewertet und gegebenenfalls an eine übergeordnete Steuerung weitergeleitet.

Diese Vorgehensweise hat mehrere Nachteile. Zum einen fließt kontinuierlich ein Eingangsstrom vom ca. 2 bis 10 mA, solange das Eingangssignal von 0 Volt verschieden ist. Folglich entsteht in der Eingangsschaltung durch das kontinuierliche Anliegen des Eingangssignals Verlustwärme, wenn das Eingangssignal von 0 Volt verschieden ist. Diese Verlustwärme muß abgeführt werden und verhindert eine Miniaturisierung der Eingangsschaltung. Ferner ist bei niedrigen Eingangsströmen unter 2 mA die Einkopplung von elektrischen Störsignalen sehr kritisch. Diese Einkopplung kann meist nur durch aufwendige Entstörmaßnahmen beseitigt werden.

Aus der Zusammenfassung zu JP-A-580 87 467 aus "Patent abstracts of Japan" ist eine Schaltung bekannt, mit der thermische Abhängigkeiten bei der Erfassung von Eingangsimpulsen durch ein spezielles Glättungsverfahren verbessert werden.

Die Aufgabe der vorliegenden Erfindung besteht darin, ein Betriebsverfahren für eine Eingangsschaltung und die hierzu korrespondierende Eingangsschaltung zur Verfügung zu stellen, welche die obengenannten Probleme beseitigen.

Die Aufgabe wird für das Betriebsverfahren durch das Kennzeichen des Anspruchs 1 und für die Eingangsschaltung durch das Kennzeichen des Anspruchs 6 gelöst.

Vorteilhafte Ausgestaltungen des Betriebsverfahrens ergeben sich aus den Ansprüchen 2 bis 5, vorteilhafte Ausgestaltungen der Eingangsschaltung aus den Ansprüchen 7 bis 9. Weitere Vorteile und Einzelheiten ergeben sich aus der nachfolgenden Beschreibung eines Ausführungsbeispiels. Dabei zeigen:
- FIG 1 bis 4: verschiedene Eingangsschaltunaen und
- FIG 5 und 6: die Signalverläufe für Gleich- und Wechselspannungssignale.

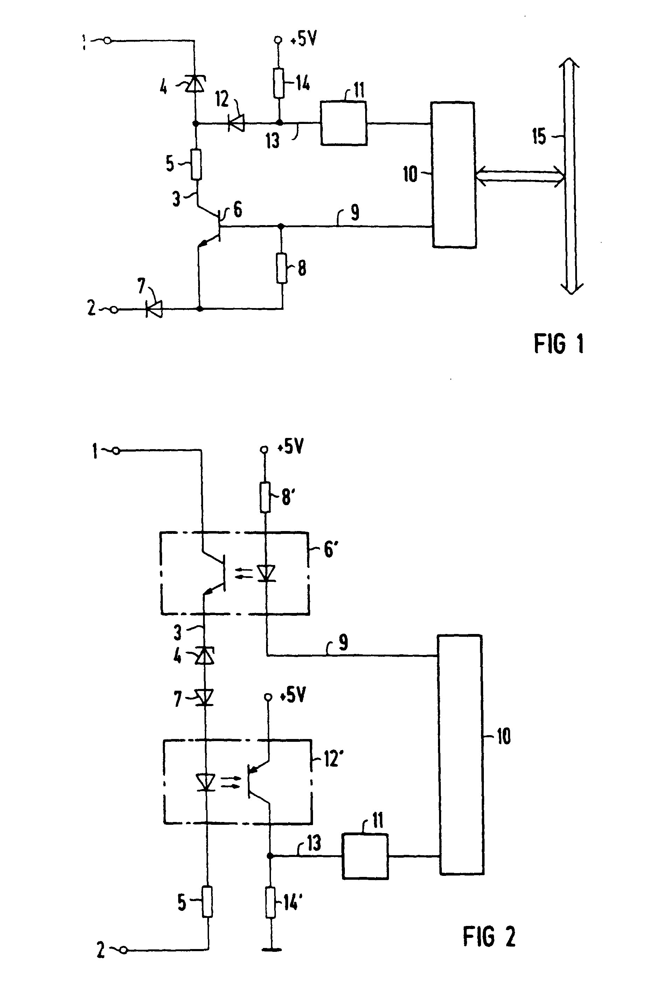

Gemäß FIG 1 weist die Eingangsschaltung einen Signalanschluß 1 und einen Bezugssignalanschluß 2 auf, welche über die Verbindungsleitung 3 miteinander verbunden sind. Über den Signalanschluß 1 ist der Eingangsschaltung ein Eingangssignal zuführbar, über den Bezugssignalanschluß 2 ein Bezugspotential. In der Verbindungsleitung 3 befindet sich eine Reihenschaltung, welche aus einer Z-Diode 4, einem Widerstand 5, einem Transistor 6 und einer Diode 7 besteht. Die Basis des Transistors 6 ist über den Vorwiderstand 8 mit dem Bezugspotential und über die Steuerleitung 9 mit der Steuer- und Auswerteschaltung 10 verbunden.

Die Steuer- und Auswerteschaltung 10 ist ferner mit der Signalerfassungsschaltung 11 verbunden, die über die Entkoppeldiode 12 an die Verbindungsleitung 3 angeschlossen ist. Die Signalleitung 13 ist über den Pullwiderstand 14 mit dem Versorgungspotential verbunden.

Die Signalerfassung funktioniert wie folgt:

Wenn an der Steuerleitung 9 kein Steuersignal ansteht, sperrt der Transistor 6. Er trennt also die Verbindungsleitung 3 auf. Dadurch kann über den Widerstand 5 kein Strom fließen. Die Steuer- und Auswerteschaltung 10 steuert daher von Zeit zur Zeit, z.B. jede ms, den Transistor 6 für kurze Zeit an, so daß der Transistor 6 die Verbindungsleitung 3 schließt. Die Ansteuerzeit ist erheblich kleiner als die Zeit zwischen zwei Ansteuerungen. Die Ansteuerzeit beträgt z.B. nur 1/1000 der Periode, wäre im vorliegenden Fall also eine µs.

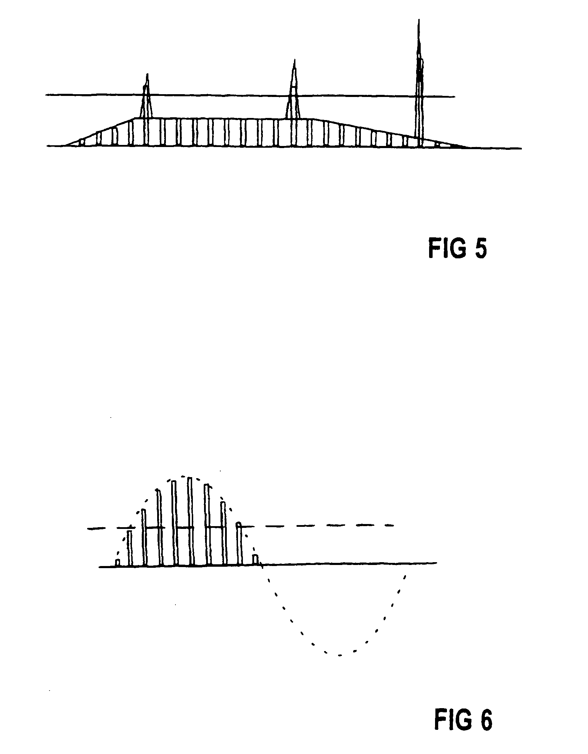

Der während der Ansteuerung an der Signalerfassungsschaltung 11 anliegende Signalpegel wird von der Signalerfassungsschaltung 11 erfaßt und zu diesem Zeitpunkt an die Steuer- und Auswerteschaltung 10 weitergeleitet. Diese nimmt eine Vorverarbeitung des Signals vor - darauf wird später noch in Verbindung mit FIG 5 und 6 näher eingegangen - und meldet das Auswertungsergebnis über den Bus 15 weiter an eine übergeordnete Einheit. Die übergeordnete Einheit kann beispielsweise die Zentraleinheit einer speicherprogrammierbaren Steuerung sein.

Wenn das der Eingangsschaltung über den Signalanschluß 1 zugeführte Eingangssignal logisch-Null ist, also unter der Zenerspannung der Z-Diode 4 liegt, fließt Strom über den Pullwiderstand 14, die Diode 12, den Widerstand 5, den Transistor 6 und die Diode 7. Das an der Signalerfassungsschaltung 11 anstehende Signal ist daher aufgrund des Spannungsabfalls über den Widerstand 14 ebenfalls logisch-Null.

Wenn das am Signalanschluß 1 anstehende Eingangssignal hingegen oberhalb der Zenerspannung der Zener-Diode 4 liegt, schaltet die Zener-Diode 4 durch. In der Folge sperrt die Entkoppeldiode 12. Die Signalleitung 13 wird folglich durch den Pullwiderstand 14 auf logisch-Eins gelegt. Dieses Signal wird dann von der Signalerfassungsschaltung 11 erfaßt und an die Steuer- und Auswerteschaltung 10 weitergemeldet.

Bei der Dimensionierung der Schaltung ist folgendes zu beachten:
- die Zenerdiode 4 legt die Schaltschwelle des Eingangssignals fest, bei welcher das von der Signalerfassungsschaltung 11 detektierte Signal von Null auf Eins wechselt. Die so bestimmte Schranke sollte zwischen 30 und 60% des maximal zulässigen Nennwerts des Eingangssignals liegen. Wenn das dem Signalanschluß 1 zugeführte Signal z.B. ein Gleichspannungssignal von 24 Volt ist, sollte die Zenerspannung der Z-Diode 4 z.B. bei 10 Volt liegen.
- Der Widerstand 5 muß so dimensioniert sein, daß die durch Normen vorgeschriebenen Mindest- und Höchstwerte zum Ansprechen der Schaltung beachtet werden.
- Die Diode 7 ist nur dann erforderlich, wenn bei einem versehentlichen Vertauschen von Signal- und Bezugsspannung die Sperrspannung des Transistors 6 allein nicht ausreicht.

Die Schaltung gemäß FIG 1 ist eine potentialgebundene Eingangsschaltung. Mit anderen Worten: Die Signalerfassungsschaltung 11 und der Transistor 6 als Schaltelement sind direkt an die Verbindungsleitung 3 angekoppelt. FIG 2 zeigt demgegenüber eine potentialgetrennte Eingangsschaltung. In diesem Fall ist der Schalttransistor 6 durch den Optokoppler 6' ersetzt. Ferner ist auch die Signalerfassungsschaltung 11 über den Optokoppler 12' an die Verbindungsleitung 3 angeschlossen. Den Optokopplern 6',12' sind selbstverständlich zur Strombegrenzung Widerstände 8',14' beigeordnet. Ansonsten ist der Aufbau der potentialgetrennten Eingangsschaltung gemäß FIG 2 analog zu dem potentialgebundenen Aufbau gemäß FIG 1. Gleiche Elemente sind daher in FIG 2 mit dem gleichen Bezugszeichen versehen wie in FIG 1.

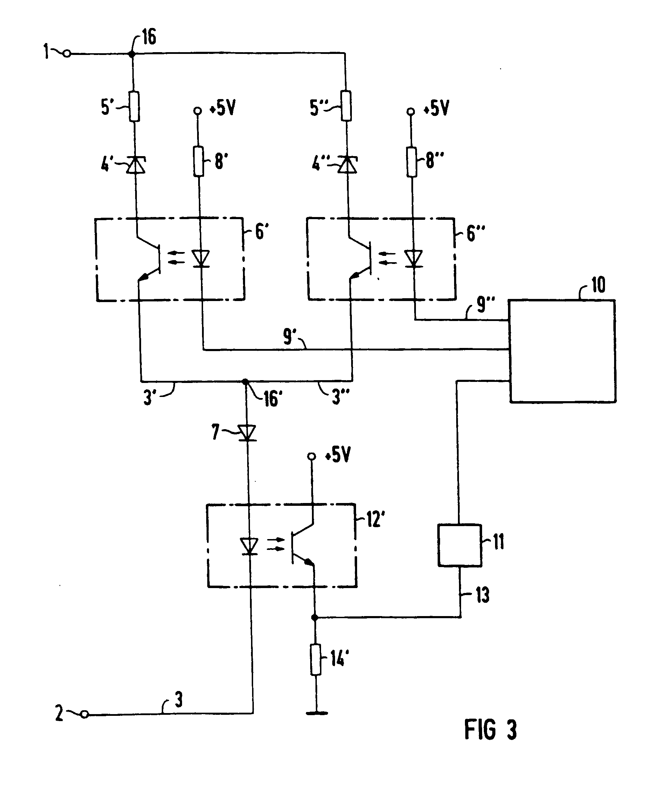

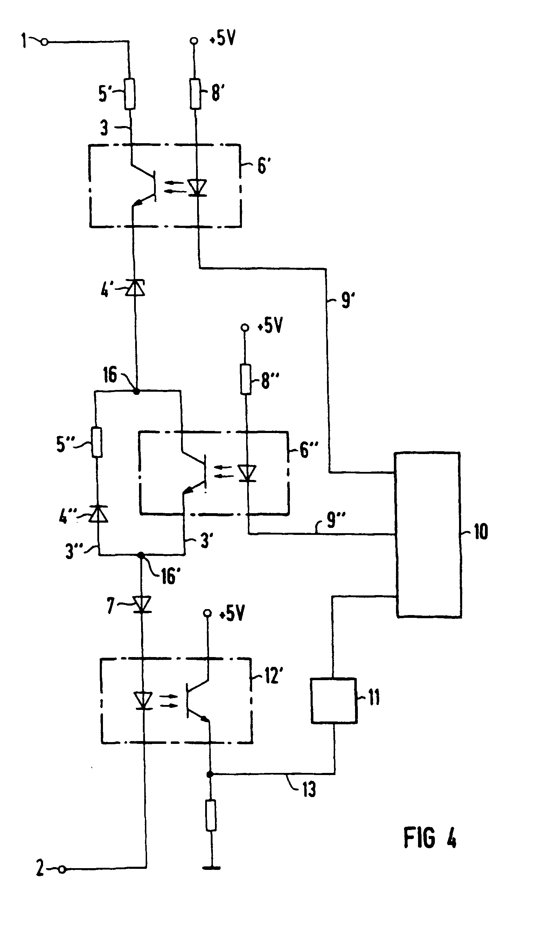

Bei entsprechender Ausgestaltung der Eingangsschaltung ist diese auch für mehrere verschiedene Spannungen verwendbar. Beispiele hierfür sind in den FIG 3 und 4 dargestellt.

Gemäß FIG 3 weist eine derartige Eingangsschaltung zwar eine einzige Signalerfassungschaltung 11 auf, welche wiederum über einen Optokoppler 12' an die Verbindungsleitung 3 angeschlossen ist. Die Verbindungsleitung 3 spaltet sich aber zwischen den Knotenpunkten 16,16' in zwei Zweige 3',3" auf. In jedem Zweig 3',3" sind dann je ein Widerstand 5',5", je eine Z-Diode 4',4" und je ein Optokoppler 6', 6" angeordnet.

Die Zenerspannung der Zenerdiode 4' beträgt beispielsweise 10 Volt, während die der Zenerdiode 4" 100 Volt beträgt. Die Widerstände 5',5" sind dementsprechend auf Eingangssignale von 24 Volt Gleichspannung bzw. 230 Volt Wechselspannung dimensioniert. Durch Ansteuern nur des Zweiges 3' über die Steuerleitung 9' bzw. nur des Zweiges 3" über die Steuerleitung 9" kann dann alternativ eine der beiden Signalarten (24V= oder 230V-) über die Signalleitung 13 erfaßt werden.

Demgegenüber zeigt FIG 4 eine Abwandlung von FIG 3. Hier sind die Zenerdioden 4',4" nicht parallel zueinander, sondern hintereinander geschaltet. Ihre Zenerspannungen betragen daher nicht 10 und 100 Volt, sondern 10 und 90 Volt. Ebenso sind auch die Widerstände 5',5" hintereinander geschaltet. Wenn mit dieser Schaltung ein 230 Volt-Wechselspannungsignal erfaßt werden soll, wird nur der Optokoppler 6' über die Steuerleitung 9' angesteuert. Wenn dagegen ein 24 Volt-Gleichspannungssignal erfaßt werden soll, werden beide Optokoppler 6, 6' über die Steuerleitungen 9',9" angesteuert.

Mit den erfindungsgemäßen Eingangsschaltungen ergeben sich völlig neue Möglichkeiten zur Signalerfassung. Bisher wurde das Eingangssignal kontinuierlich erfaßt und von Zeit zur Zeit an eine übergeordnete Steuerung übermittelt. Eine Vorverarbeitung des erfaßten Signals erfolgte nicht. Bei der vorliegenden Erfindung hingegen ist es möglich, mit einer Abtastfrequenz von z.B. 1 kHz Meßwerte für das zugeführte Eingangssignal zu bestimmen und eine vorbestimmte Anzahl von zeitlich aufeinanderfolgenden Meßwerten zusammen auszuwerten.

Wenn das zuerfassende Eingangssignal z.B. ein Gleichspannungssignal ist, kann man z.B. stets drei aufeinanderfolgende Signale erfassen und in der Steuer- und Auswerteschaltung 10 gemeinsam auswerten. Als tatsächlich weiterverarbeitetes Signal wird das Signal verwendet, welches bei mindestens zwei der drei Messungen erfaßt wurde. Hierdurch ist es möglich, kurzfristige Störspitzen, die im erfaßten Signal auftreten können, auszufiltern und dennoch eine schnelle Reaktion auf Signaländerungen zu gewährleisten. Ein derartiges mit Störspitzen versehenes Signal ist in FIG 5 dargestellt. Die waagrechte Linie in FIG 5 soll dabei die vorbestimmte Schranke bedeuten, welche durch die Zenerdiode 4 in der Verbindungsleitung 3 festgelegt ist.

Wenn das zu erfassende Signal hingegen ein Wechselspannungssignal mit einer Wechselspannungsfrequenz ist, muß diese erheblich kleiner sein als die Abtastfrequenz. Ferner muß die Anzahl aufeinanderfolgender Meßwerte, welche zusammen ausgewertet werden, mindestens in etwa dem Verhältnis von Abtastfrequenz zu Wechselspannungsfrequenz entsprechen. Ein Beispiel soll dies näher erläutern:

Wenn die Meßwerte mit einer Abtastfrequenz von 1 kHz abgetastet werden und das zu erfassende Signal die übliche Netzspannungsfrequenz von 50 bzw. 60 Hz aufweist, sollte die vorbestimmte Anzahl mindestens 20 bzw. 16 oder 17 sein.

Da ferner - vergleiche FIG 6 - während der halben Wechselspannungsperiode das erfaßte Signal negativ und damit sicher unterhalb der durch die Z-Diode festgelegten Schaltschwelle (= gestrichelte Linie in FIG 6) liegt, muß die vorbestimmte Teilanzahl, oberhalb derer das erfaßte Signal als Eins gewertet wird, kleiner als die Hälfte der Anzahl sein. Typisch sollte die Teilanzahl in etwa gleich einem Viertel der gesamten Anzahl sein.

Wenn gemäß dem obigen Beispiel die Netzfrequenz 50 Hz und die Abtastfrequenz 1 kHz beträgt sowie die vorbestimmte Anzahl folglich 20 ist, sollte die Teilanzahl zwischen 4 und 7 liegen. Es könnte also beispielsweise auf Eins erkannte werden, wenn 5 oder mehr als 5 von 20 aufeinanderfolgenden Meßwerten eine logische Eins liefern. In den anderen Fällen ist auf Null zu erkennen.

Durch das Abtasten des Eingangssignals kann die entstehende Verlustleistung deutlich reduziert werden. In der Praxis treten daher kaum noch Wärmeprobleme mehr auf. Folglich kann die Schaltung miniaturisiert werden. Insbesondere ist es möglich, die Schaltung in einem integrierten Schaltkreis anzuordnen. Dies stellt einen erheblichen Vorteil dar. Darüber hinaus ermöglicht es das Abtasten der Eingangssignale auch, während der kurzen Abtastzeiten einen erhöhten Strom fließen zu lassen. Hierdurch können die Störbeeinflussungen ohne aufwendige Entstörschaltungen deutlich verringert werden.

## Patentansprüche

1. Betriebsverfahren für eine Eingangsschaltung, der von außen ein Eingangssignal zugeführt wird,
**dadurch gekennzeichnet ,**
- **dass** das Eingangssignal über eine Verbindungsleitung (3) und ein in der Verbindungsleitung (3) angeordnetes Schaltelement (6, 6',6") mit einem Bezugspotential verbunden wird,
- **dass** das Schaltelement (6, 6', 6") abwechselnd geöffnet und geschlossen wird und
- **dass** Messwerte für das der Eingangsschaltung zugeführte Eingangssignal nur dann erfasst und ausgewertet werden, wenn das Schaltelement (6,6',6") geschlossen ist.

2. Betriebsverfahren nach Anspruch 1, **dadurch**
**gekennzeichnet ,**
- **dass** das zugeführte Eingangssignal ein Binärsignal ist,
- **dass** eine vorbestimmte Anzahl von zeitlich aufeinanderfolgenden Messwerten zusammen ausgewertet wird,
- **dass** das Auswertungsergebnis ein Einssignal ist, wenn mindestens eine vorbestimmte Teilanzahl der Messwerte oberhalb einer bestimmten Schranke liegt, und
- **dass** das Auswertungsergebnis ein Nullsignal ist, wenn weniger als die vorbestimmte Teilanzahl der Messwerte oberhalb der vorbestimmten Schranke liegt.

3. Betriebsverfahren nach Anspruch 1, **dadurch**
**gekennzeichnet ,**
- **dass** das Eingangssignal ein Gleichspannungssignal ist,
- **dass** eine vorbestimmte Anzahl von zeitlich aufeinanderfolgenden Messwerten zusammen ausgewertet wird,
- **dass** das Auswertungsergebnis ein Einssignal ist, wenn mindestens eine vorbestimmte Teilanzahl der Messwerte oberhalb einer bestimmten Schranke liegt,
- **dass** das Auswertungsergebnis ein Nullsignal ist, wenn weniger als die vorbestimmte Teilanzahl der Messwerte oberhalb der vorbestimmten Schranke liegt,
- **dass** die Anzahl von Messwerten ungerade ist und
- **dass** die Teilanzahl die kleinste ganze Zahl ist, die größer als die Hälfte der Anzahl ist.

4. Betriebsverfahren nach Anspruch 1, **dadurch**
**gekennzeichnet ,**
- **dass** das Eingangssignal ein Wechselspannungssignal mit einer Wechselspannungsfrequenz ist,
- **dass** die Wechselspannungsfrequenz erheblich kleiner als die Abtastfrequenz ist,
- **dass** eine vorbestimmte Anzahl von zeitlich aufeinanderfolgenden Messwerten zusammen ausgewertet wird,
- **dass** das Auswertungsergebnis ein Einssignal ist, wenn mindestens eine vorbestimmte Teilanzahl der Messwerte oberhalb einer bestimmten Schranke liegt,
- **dass** das Auswertungsergebnis ein Nullsignal ist, wenn weniger als die vorbestimmte Teilanzahl der Messwerte oberhalb der vorbestimmten Schranke liegt,
- **dass** die vorbestimmte Anzahl mindestens in etwa dem Verhältnis von Abtastfrequenz zu Wechselspannungsfrequenz entspricht, und
- **dass** die vorbestimmte Teilanzahl kleiner als die Hälfte der Anzahl, insbesondere in etwa gleich einem Viertel der Anzahl, ist.

5. Betriebsverfahren nach Anspruch 2, 3 oder 4,
**dadurch gekennzeichnet , dass** das Eingangssignal einen maximal zulässigen Nennwert aufweist und dass die vorbestimmte Schranke zwischen 30 und 60% des maximal zulässigen Nennwerts liegt.

6. Eingangsschaltung, bestehend aus
- einem Signalanschluss (1), über den der Eingangsschaltung ein Eingangssignal zuführbar ist,
- einer Verbindungsleitung (3), über welche der Signalanschluss (1) mit einem Bezugspotential verbindbar ist, und
- einer an die Verbindungsleitung (3) angekoppelten Signalerfassungsschaltung (11) zur Erfassung des der Eingangsschaltung über den Signalanschluss (1) zugeführten Signals,
**dadurch gekennzeichnet ,**
**dass** sie
- ein in der Verbindungsleitung (3) angeordnetes Schaltelement (6,6', 6"), mittels dessen die Verbindungsleitung (3) schließ- und auftrennbar ist, und
- eine mit dem Schaltelement (6, 6',6") und der Signalerfassungsschaltung (11) verbundene Steuer- und Auswerteschaltung (10)
aufweist, wobei die Steuer-und Auswerterschaltung (10) zur Schließung des Schaltelements (6,6',6") nur während der Erfassung und Auswertung von Messweiten für das der Eingangsschaltung zuführbare Eingangssignal vorgesehen ist.

7. Eingangsschaltung nach Anspruch 6, **dadurch gekennzeichnet , dass** in der Verbindungsleitung (3) eine in Sperrrichtung geschaltete Zenerdiode (4,4') angeordnet ist.

8. Eingangsschaltung nach Anspruch 6 oder 7,
**dadurch gekennzeichnet, dass** die Verbindungsleitung (3) zwischen zwei Knotenpunkten (16,16') in mindestens zwei Zweige (3',3") aufgeteilt ist und dass zumindest in einem Zweig (3") eine in Sperrichtung geschaltete Zweig-Z-Diode (4") und im anderen Zweig (3') ein Zweigschaltelement (6") angeordnet ist.

9. Eingangsschaltung nach Anspruch 8, **dadurch gekennzeichnet , dass** das Zweigschaltelement (6") als Optokoppler ausgebildet ist.

## Claims

1. Operating method for an input circuit to which an input signal is supplied from the outside, **characterized**
- **in that** the input signal is connected to a reference-earth potential via a connecting line (3) and a switching element (6, 6', 6") which is arranged in the connecting line (3),
- **in that** the switching element (6, 6', 6") is alternately opened and closed, and
- **in that** measurements for the input signal which is supplied to the input circuit are taken and evaluated only when the switching element (6, 6', 6") is closed.

2. Operating method according to Claim 1, **characterized**
- **in that** the supplied input signal is a binary signal,
- **in that** a predetermined number of successive measurements are evaluated together,
- **in that** the evaluation result is a one signal when at least a predetermined portion of the number of the measurements is above a specific limit, and
- **in that** the evaluation result is a zero signal when less than the predetermined portion of the number of the measurements is above the predetermined limit.

3. Operating method according to Claim 1, **characterized**
- **in that** the input signal is a DC voltage signal,
- **in that** a predetermined number of successive measurements are evaluated together,
- **in that** the evaluation result is a one signal when at least a predetermined proportion of the number of the measurements is above a specific limit,
- **in that** the evaluation result is a zero signal when less than the predetermined proportion of the number of the measurements is above the predetermined limit,
- **in that** the number of measurements is odd, and
- **in that** the portion of the number is the smallest integer number which is greater than half the number.

4. Operating method according to Claim 1, **characterized**
- **in that** the input signal is an AC voltage signal at an AC voltage frequency,
- **in that** the AC voltage frequency is considerably lower than the sampling frequency,
- **in that** a predetermined number of successive measurements are evaluated together,
- **in that** the evaluation result is a one signal when at least a predetermined proportion of the number of the measurements is above a specific limit,
- **in that** the evaluation result is a zero signal when less than the predetermined proportion of the number of the measurements is above the predetermined limit,
- **in that** the predetermined number corresponds at least approximately to the ratio of the sampling frequency to the AC voltage frequency, and
- **in that** the predetermined portion of the number is less than half the number, in particular is approximately equal to one quarter of the number.

5. Operating method according to Claim 2, 3 or 4, **characterized in that** the input signal has a maximum permissible nominal value, and **in that** the predetermined limit is between 30 and 60% of the maximum permissible nominal value.

6. Input circuit, comprising
- a signal connection (1) via which an input signal can be supplied to the input circuit,
- a connecting line (3) via which the signal connection (1) can be connected to a reference-earth potential, and
- a signal detection circuit (11), which is coupled to the connecting line (3), for detecting the signal which is supplied to the input circuit via the signal connection (1),
**characterized in that** it
- is a switching element (6, 6', 6") which is arranged in the connecting line (3) and by means of which the connecting line (3) can be closed and opened, and
- has a control and evaluation circuit (10) which is connected to the switching element (6, 6' 6") and to the signal detection circuit (11),
with the control and evaluation circuit (10) being provided for closing the switching element (6, 6', 6") only during the detection and evaluation of measurements for the input signal that can be supplied to the input circuit.

7. Input circuit according to Claim 6, **characterized in that** a zener diode (4, 4'), which is connected in the reverse direction, is arranged in the connecting line (3).

8. Input circuit according to Claim 6 or 7, **characterized in that** the connecting line (3) is split between two nodes (16, 16') into at least two paths (3', 3"), and **in that** a path zener diode (4"), which is connected in the reverse direction, is arranged in at least one path (3"), and a path switching element (6") is arranged in the other path (3').

9. Input circuit according to Claim 8, **characterized in that** the path switching element (6") is designed as an optocoupler.

## Revendications

1. Procédé pour faire fonctionner un circuit d'entrée, auquel est envoyé de l'extérieur un signal d'entrée,
**caractérisé**
- **en ce que** l'on relie le signal d'entrée à un potentiel de référence par l'intermédiaire d'une ligne (3) de liaison et d'un élément (6, 6', 6") de commutation monté dans la ligne (3) de liaison,
- **en ce que** l'élément (6, 6', 6") de commutation est ouvert et fermé en alternance et
- **en ce que** l'on ne relève et n'exploite des valeurs de mesure du signal d'entrée envoyé au circuit d'entrée que si l'élément (6, 6', 6") de commutation est fermé.

2. Procédé pour faire fonctionner un circuit d'entrée suivant la revendication 1, **caractérisé**
- **en ce que** le signal d'entrée envoyé est un signal binaire,
- **en ce que** l'on exploite ensemble un nombre déterminé à l'avance de valeurs de mesure se succédant dans le temps,
- **en ce que** le résultat de l'exploitation est un signal un si au moins un sous-nombre déterminé à l'avance de valeurs de mesure dépasse une limite déterminée, et
- **en ce que** le résultat de l'exploitation est un signal zéro si moins que le sous-nombre déterminé à l'avance des valeurs de mesure soit au-dessus de la limite déterminée.

3. Procédé pour faire fonctionner un circuit d'entrée suivant la revendication 2, **caractérisé en ce que** le signal d'entrée est un signal de tension en continu, **en ce que** le nombre des valeurs de mesure est impair et **en ce que** le sous-nombre est le plus petit nombre entier qui est supérieur à la moitié du nombre.

4. Procédé pour faire fonctionner un circuit d'entrée suivant la revendication 2, **caractérisé**
- **en ce que** le signal d'entrée est un signal de tension alternative ayant une fréquence de tension alternative,
- **en ce que** la fréquence de tension alternative est considérablement plus petite que la fréquence d'échantillonnage de l'élément (6, 6', 6") de commutation,
- **en ce que** le nombre déterminé à l'avance correspond au moins à peu près au rapport de la fréquence d'échantillonnage à la fréquence de la tension alternative, et
- **en ce que** le sous-nombre déterminé à l'avance est inférieur à la moitié du nombre, notamment en étant à peu près égal à un quart du nombre.

5. Procédé pour faire fonctionner un circuit d'entrée suivant la revendication 2, 3 ou 4, **caractérisé en ce que** le signal d'entrée a une valeur nominale admissible maximum et **en ce que** la limite déterminée à l'avance est comprise entre 30 et 60 % de la valeur nominale admissible au maximum.

6. Circuit d'entrée constitué
- d'une borne (1) de signal, par laquelle un signal d'entrée peut être envoyé au circuit d'entrée,
- d'une ligne (3) de liaison, par laquelle la borne (1) de signal peut être reliée à un potentiel de référence, et
- d'un circuit (11) de détection de signal, qui est couplé à la ligne (3) de liaison et qui est destiné à détecter le signal envoyé au circuit d'entrée par l'intermédiaire de la borne (1) de signal,
**caractérisé en ce qu'**il comprend
- un élément (6, 6', 6") de commutation, qui est monté dans la ligne (3) de liaison et au moyen duquel la ligne (3) de liaison peut être fermée et coupée, et
- un circuit (10) de commande d'exploitation relié à l'élément (6, 6', 6") de commutation et au circuit (11) de détection du signal.

7. Circuit d'entrée suivant la revendication 6, **caractérisé en ce qu'**une diode (4, 4') Zener montée dans le sens à l'état bloqué est montée dans la ligne (3) de liaison.

8. Circuit d'entrée suivant la revendication 6 ou 7, **caractérisé en ce que** la ligne (3) de liaison est répartie entre deux points (16, 16') nodaux en au moins deux branches (3', 3") et **en ce qu'**au moins une diode (4") Zener de branche est montée dans le sens à l'état bloqué dans une branche (3") et un élément (6") de commutation de branche est monté dans l'autre branche (3').

9. Circuit d'entrée suivant la revendication 8, **caractérisé en ce que** l'élément (6") de commutation de branche est constitué sous la forme d'un optocoupleur.
